**Europäisches Patentamt**

**European Patent Office**

**Office européen des brevets**

(19)

(11) Veröffentlichungsnummer: **0 100 851**

**A2**

(12) # EUROPÄISCHE PATENTANMELDUNG

(21) Anmeldenummer: **83106292.2**

(22) Anmeldetag: **28.06.83**

(51) Int. Cl.³: **G 11 C 11/40**

(30) Priorität: **20.07.82 DE 3227121**

(43) Veröffentlichungstag der Anmeldung:
**22.02.84 Patentblatt 84/8**

(84) Benannte Vertragsstaaten:
**AT DE FR GB IT SE**

(71) Anmelder: **SIEMENS AKTIENGESELLSCHAFT**
**Berlin und München Wittelsbacherplatz 2**
**D-8000 München 2(DE)**

(72) Erfinder: **Wilhelm, Wilhelm, Dr.**
**Geigenbergerstrasse 23**
**D-8000 München 71(DE)**

(54) **Schaltungsanordnung zum Lesen bipolarer Speicherzellen.**

(57) Die Erfindung betrifft eine Schaltungsanordnung zum Lesen bipolarer Specherzellen, bei denen ein Speicherelement (MO, M1, R5, R6) aus zwei rückgekoppelten, jeweils aus einem Multiemittertransistor (Mo, M1) und einem Lastelement (R5, R6) gebildeten Invertern besteht und zwei komplementäre Bitleitungen (Bo, $\overline{Bo}$) aufweist, die mit je einem Emitter (EOo, EO1) der beiden Multiemittertransistoren (Mo, M1) verbunden sind und über je eine Bitleitungsstromquelle (IBO, IB1) mit einem ersten Potential ($V_{EE}$) verbindbar sind, mit einem Differenzverstärker (DO), dessen Eingänge über die Kollektor-Emitter-Strecken von Lesetransistoren (TL1, TL2) mit den komplementären Bitleitungen (Bo, $\overline{Bo}$) verbunden sind. Jede Bitleitung (Bo, $\overline{Bo}$) ist über eine Diodenstrecke (TL1, TL2) mit einer, von einem zweiten Potential ($V_{CC}$) beaufschlagten Lesestromquelle (IA) verbunden.

FIG 2

0100851

SIEMENS AKTIENGESELLSCHAFT
Berlin und München

Unser Zeichen

82 P 1559 E

Schaltungsanordnung zum Lesen bipolarer Speicherzellen

Die Erfindung betrifft eine Schaltungsanordnung nach dem Oberbegriff des Patentanspruchs 1.

Entsprechende Schaltungsanordnungen sind z.B. aus K.Kawarada e.a.,IEEEJournal of Solid State Circuits, Vol.SC-13 Nr.5, Okt. 1978, Seiten 656 bis 663, U.Bürker und H.Glock, IEEEInternational Solid-State Circuit Conference 1979, S.102 und 103 und EP-A1-0 019988 (insbes. Fig.2) bekannt. Der Lesevorgang bei den bekannten Schaltungsanordnungen beruht auf einer Abfrage der Speicherzellenpotentiale hinsichtlich eines festen Referenzpotentials.

Die Information eines aus zwei rückgekoppelten Invertern gebildeten Speicherelementes steckt im Vorzeichen der Kreuzkopplungsdifferenzspannung eines Speicherelementes. Um zu einer eindeutigen Lesespannung zu gelangen, muß das Referenzpotential genau zwischen dem Potentialen der Kreuzkopplungsdifferenz liegen. Da nun die Kreuzkopplungspotentiale von einer Reihe von Parametern abhängen, die Streuungen, Temperatur-und Versorgungseinflüssen unterworfen sind, ist es schwierig oder gar unmöglich, das richtige Referenzpotential zu finden. In den bekannten Schaltungsanordnungen versucht man, diesen Schwierigkeiten durch einen möglichst großen Kreuzpotentialunterschied aus dem Wege zu gehen. Dieses Vorgehen ist aber mit einigen Nachteilen verbunden.

1. Die Bitleitungshübe sind mehrere 100 mW groß. Dies führt zu einer Erhöhung der Zugriffszeit, da die Umladung der kapazitiv stark belasteten Leitung Zeit kostet.

Nte 1 Pe / 15.7.82

2. Im Übergangsbereich (d.h. beim Adresswechsel) wenn sich zwei Zellen gegenseitig ablösen, ist das Lesesignal nicht eindeutig.

3. Genaue Toleranzrechnungen und u.U. mehrere Einstellversuche durch Redesigns sind notwendig, um fertigbare Speicherbausteine zu entwickeln.

4. Der volle Bitleitungsstrom fließt in die aus Platzgründen mit Minimalstrukturen aufgebaute Speicherzelle und überlastet sie.

Aufgabe der vorliegenden Erfindung ist es, hier Abhilfe zu schaffen und eine Schaltungsanordnung zum Lesen bipolarer Speicherzellen vorzusehen, bei der Streuungen eliminiert und die Signalhübe reduziert werden.

Diese Aufgabe wird bei einer Anordnung der eingangs genannten Art erfindungsgemäß durch die kennzeichnenden Merkmale des Anspruchs 1 gelöst.
Somit gelingt es, auf eine feste Referenzspannung zu verzichten und lediglich Differenzpotentiale abzufragen. Streuungen werden somit eliminiert und Signalhübe reduziert.

Ausgestaltungen der Erfindung sind in Unteransprüchen gekennzeichnet.

Die Erfindung wird im folgenden anhand der Figuren näher erläutert. Es zeigen:
Die Fig.1 das Prinzipschaltbild der Informationsabfrage einer in eine Speichermatrix eingebetteten Zelle nach dem Stand der Technik,
die Fig.2 das Prinzipschaltbild der Informationsabfrage einer in eine Speichermatrix eingebettete Zelle einer erfindungsgemäßen Schaltungsanordnung,

die Fig.3 ein Schaltungsbeispiel für eine erfindungsgemäße Schaltungsanordnung mit einem Speicher mit mehreren Bitleitungspaaren und einer vorteilhafterweise verwendbaren Lesestromquelle und

die Fig.4 ein weiteres Schaltungsbeispiel für eine erfindungsgemäße Schaltungsanordnung, das mit nur zwei Sammelschienen auskommt.

In den Figuren sind gleiche Elemente mit gleichen Bezugszeichen bezeichnet.

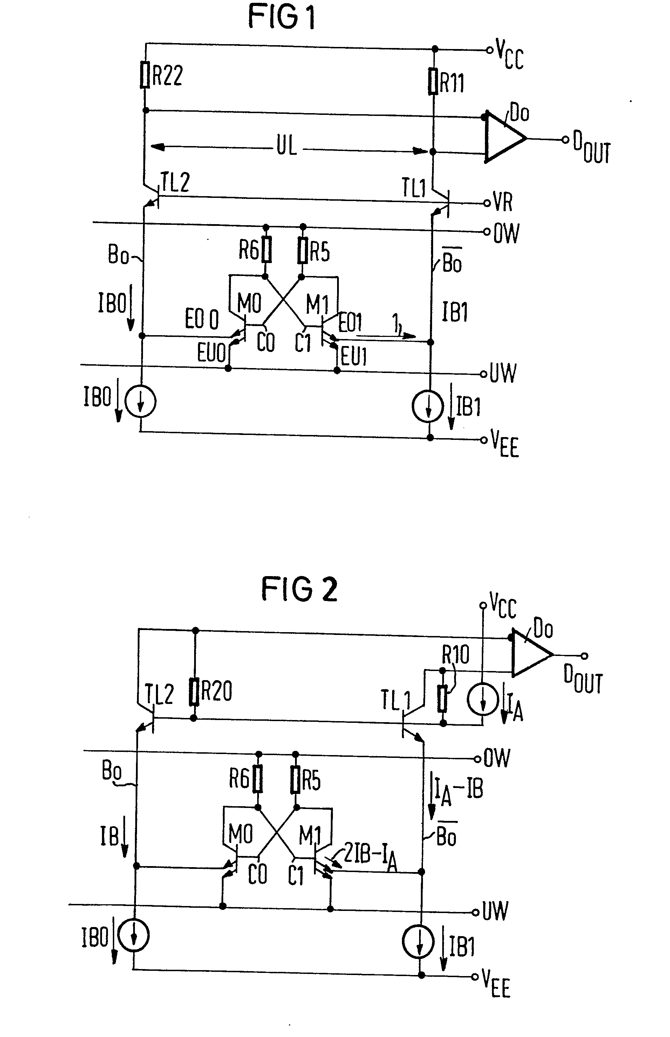

Die Figur 1 zeigt eine Speicherzelle mit zugehöriger Leseschaltung wie sie aus dem Stand der Technik, beispiels- weise den eingangs genanten Literaturstellen, bekannt ist. Aus Gründen der Übersichtlichkeit ist in der Figur 1 nur ein Speicherlement aus einer Speichermatrix dargestellt. Das Speicherlement besteht aus zwei rückgekoppelten Invertern, wobei der erste Inverter aus dem Lastelement R6 und dem Multiemittertransistor MO und der zweite Inverter aus dem Lastelement R5 und dem Multiemittertransistor M1 gebildet ist. Die beiden Multiemittertransistoren Mo und M1 sind kreuzgekoppelt, die beiden Inverter bilden somit ein Flip-Flop.

Die beiden Multiemittertransistoren Mo und M1 weisen je zwei Emitter EOO, EUO bzw. EO1, EU1 auf, wobei jeweils ein Emitter EOO bzw. EO1 eines Multiemittertransistors MO bzw. M1 mit einer Bitleitung Bo bzw. $\overline{Bo}$ verbunden ist, während die zweiten Emitter EUO bzw. EU1 mit einer unteren Wortleitung UW verbunden sind.

Das Speicherelement liegt zwischen einer oberen Wortleitung OW und zwischen der unteren Wortleitung UW, durch die ein von einer in der Figur nicht gezeigten Stromquelle kommender konstanter Strom fließt und zwischen dem Bitleitungspaar
Bo und $\overline{Bo}$. Die obere Wortleitung OW ist über einen in der
Figur nicht gezeigten Wortleitungsdecoder anwählbar,
während das Bitleitungsppar Bo und $\overline{Bo}$ über einen in der
Figur nicht gezeigten Bitleitungsdecoder auswählbar sind.
Im Falle der Auswahl der Bitleitungen Bo und $\overline{Bo}$ sind die
Konstantstromquellen IBO und IB1, die die Bitleitungen
Bo und $\overline{Bo}$ mit einem ersten Potential $V_{EE}$
verbinden, eingeschaltet.

Die Auswerteschaltung nach dem Stand der Technik besteht
aus zwei Lesetransistoren TL1 und TL2, deren Basiselektroden
mit einer Referenzspannung VR verbunden sind. Die Emitter
der Transistoren TL1,TL2 sind mit den Bitleitungen Bo bzw.
$\overline{Bo}$ verbunden. Die Kollektoren der Lesetransistoren TL1, TL2
sind einerseits über Widerstände R11, R22 mit einem zweiten
Potential (Versorgungsspannung) $V_{cc}$ und andererseits mit
je einem Eingang eines Differenzverstärkers Do, an dessen
Ausgang $D_{out}$ das gelesene Datenbit entnehmbar ist, verbunden.

Der Lesevorgang bei den bekannten bipolaren Speichern ruht
nun auf einer Abfrage der Zellenpotentiale hinsichtlich
des festen Referenzpotentials VR. Die Information des Speicherelementes steckt im Vorzeichen der Kreuzkopplungsdifferenzspannung C1 - CO der Zelle, wobei C1 die an der Basis des
Multiemittertransistors M1 liegende Spannung und CO die
an der Basis des Multiemittertransistors MO liegende Spannung
bezeichnen.

Um zu einer eindeutigen, an den Eingängen des Differenzver
stärkers Do liegenden Lesespannung UL zu gelangen, muß das
Referenzpoltential VR genau zwischen den Potentialen C1 und
CO liegen. D.h. beispielsweise für das Lesen einer "1" muß das Potential C1 größer als das Referenzpotential VR sein, damit das Speicherelement den Bitleitungsstrom IB1, der dann über den Emitter EO1 des Multiemittertransistors M1 (vgl. Pfeil 1) fließt, übernimmt. Gleichzeitig muß das Potential CO kleiner als das Referenzpotential VR sein, damit der Lesetransistor TL2 den Bitleitungsstrom IBO zum Lesewiderstand R22 führt. Beim Lesen einer "O" muß dagegen das Potential C1 kleiner als das Referenzpotential VR sein, so daß der Bitleitungsstrom IB1 der Bitleitung Bo nicht durch das Speicherelement sondern durch den Lesetransistor TL1 zum Lesewiderstand R11 fließt.

Da nun die Kreuzkopplungspotentiale C1 und CO von einer Reihe von Paramtern abhängen, die Streungen, Temperatur- und Versorgungseinflüssen unterworfen sind, ist es schwierig oder gar unmöglich, das richtige Referenzpotential zu finden.

In der bekannten Schaltung nach Figur 1 versucht man, diesen Schwierigkeiten durch einen möglichst großen Potentialunterschied zwischen den Potentialen Co und C1 aus dem Weg zu gehen. Dieses Vorgehen ist aber mit einigen Nachteilen verbunden.

1. Die Bitleitungshübe sind mehrere 100mW groß. Das führt zu einer Erhöhung der Zugriffszeit, da die Umladung der kapazitiv stark belasteten Leitung Zeit kostet.

2. Im Übergangsbereich (Adresswechsel), wo sich zwei Zellen gegenseitig ablösen, sind die Ströme durch die Lesetransistoren TL1 und TL2 null oder gleich groß und damit das Lesesignal UL nicht eindeutig.

3. Genaue Toleranzrechnungen und u.U. mehrere Einstellversuche durch Redesigns sind notwendig, um fertigbare Speicherbausteine zu entwickeln.

4. Der volle Bitleitungsstrom IBO bzw. IB1 fließt in die aus Platzgründen mit Minimalstrukturen aufgebaute Zelle und überlastet sie.

All diesen Nachteilen kann man nun erfindungsgemäß durch eine differentiell arbeitende Abfrageschaltung begegnen. Eine solche Schaltung mit einer in eine nicht dargestellte Speichermatrix eingebetteten Speicherzelle zeigt die Fig.2. Die Schaltungsanordnung nach Figur 2 unterscheidet sich von der nach Figur 1 dadurch, daß die Basiselektroden der Lesetransistoren TL1 und TL2 nicht von einer Referenzspannung VR beaufschlagt werden, sondern mit einer Lesestromquelle IA, die vom zweiten Potential bzw. der Versorgungsspannung $V_{cc}$ versorgt wird, verbunden sind. Die Kollektorwiderstände R20 bzw. R10 der Lesetransistoren TL2 bzw. TL1 sind zwischen Basis und Kollektor dieser Transistoren geschaltet.

Bei dieser Schaltungsanordnung sind die Basiselektroden der Lesetransistoren TL1 und TL2 nicht mehr an ein festes Potential VR geknüpft, die Abfrageschaltung "floatet". Sie wird von drei Stromquellen, nämlich den Bitleitungsstromquellen IBO und IB1 und der Lesetromquelle IA angesteuert, die so beschaffen sind, daß ihr Summenstrom positiv bleibt.

Haben beispielsweise die Ströme der Stromquellen IBO und IB1 die Stromstärke IB und der Strom der Stromquelle IA die Stromstärke 1,6 IB so verlangt die Stromsummenbilanz, daß der Reststrom von -0,4 IB aus einer anderen Quelle kommt. Bei der Schaltungsanordnung nach Figur 2 schließt der Reststrom aus dem Zellentransistor, dessen Basis das höhere der beiden Kreuzkopplungspotentiale CO und C1 hat. Ist beispielsweise das Potential C1 an der Basis des Transistors M1 größer als das Potential CO an der Basis des Transistors MO, so fließt der Reststrom von 0,4 IB (2 x IB - IA) über den mit der Bitleitung $\overline{BO}$ verbundenen Emitter des Transistors M1.

Der Reststrom fließt also immer über den Multiemittertransistor, dessen Basispotential höher im Vergleich zum Basispotential des anderen Multiemittertransistors ist, so daß nur die Höhe der Basispotentiale zueinander zum Zellenabfragen wesentlich ist und daß Potential der Basis der Lesetransistoren TL1 und TL2 somit dem höheren Kreuzkopplungspotential CO bzw. C1 folgt.

Die Stromstärke der Stromquelle IA wird so gewählt, daß sie zwischen dem 0,5-fachen und dem einfachen der Summe der Stromstärken der Bitleitungsstromquellen IBO und IB1 liegt. Betragen z.B. die Ströme der Bitleitungsstromquellen IB1 und IBO 1mA und der Strom in der Lesestromquelle IA 1,5 mA, und ist das Potential C1 größer als das Potential CO, so fließt ein Reststrom von 0,5 mA über den mit der Bitleitung $\overline{BO}$ verbundenen Emitter des Transistors M1 zur oberen Wortleitung OW. Der Strom in der Bitleitung $\overline{BO}$ beträgt 0,5 mA, der Strom in der Bitleitung Bo 1 mA, so daß über den Lesewiderstand R2O ein Strom von 1mA und über den Lesewiderstand R1O ein Strom von 0,5 mA fließt, an den Lesewiderstände daher unterschiedliche Spannungen abfallen und somit vom Differenz-/verstärker Do ausgewertet werden können.

Da das Potential an den Basiselektroden der Lesetransistoren TL1 und TL2 dem höheren Kreuzkopplungspotential eines Speicherelementes folgt, entfallen die vorgenannten Nachteile 1-3. Wie in der Schaltung nach Figur 1 ist der Lesestrom auch hier gleich dem durch die Zelle fließenden Strom, jedoch kann hier der Bitleitungsstrom IB größer als der Zellenstrom sein, beispielsweise das 2 1/2-fache des Zellenstromes betragen. Dadurch wird die Umladung der Bitleitungen wesentlich erleichtert.

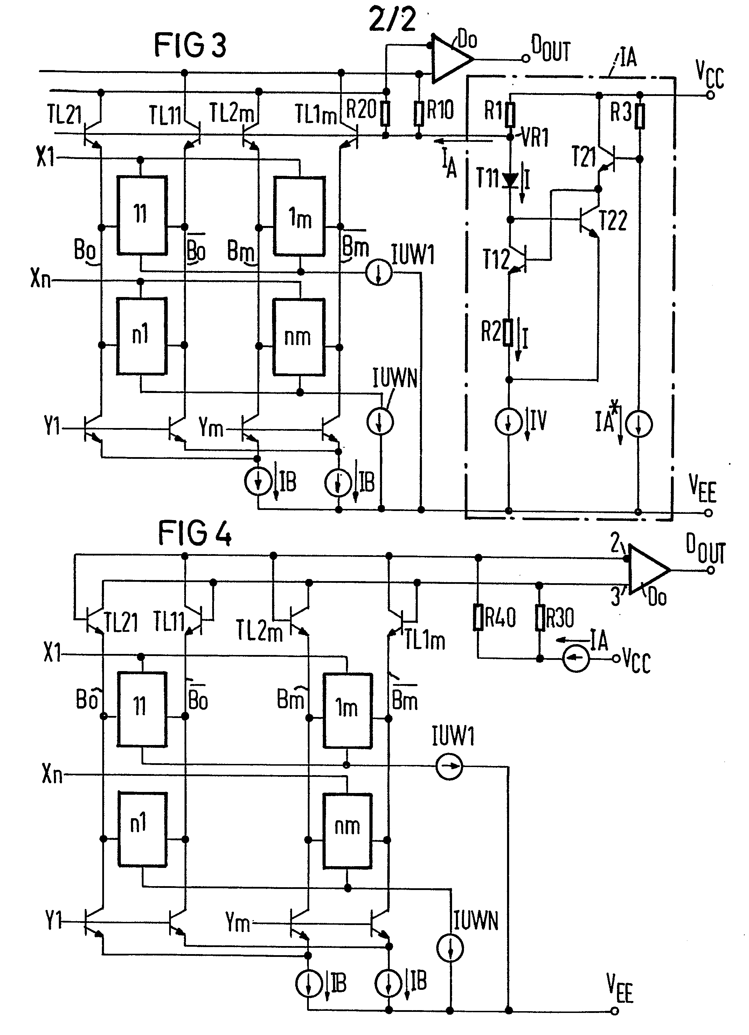

Die Figur 3 zeigt ein weiteres Schaltungsbeispiel für eine erfindungsgemäße Anordnung mit mehreren Bitleitungspaaren und einem aus Gründen der Übersichtlichkeit auf vier Speicherelemente reduziertem Speicherfeld. Die Speicherelemente 11 und 1m in der oberen Matrixzeile weisen eine gemeinsame obere Wortleitung X1 und eine gemeinsame über die Stromquelle IUW1 mit dem ersten Potential $V_{EE}$ verbundene untere Wortleitung auf. Die aus den Speicherelementen n1 und nm bestehende untere Zeile der Speichermatrix weist eine gemeinsame obere Wortleitung Xn und eine gemeinsame, über die Stromquelle IUWN mit dem ersten Potential $V_{EE}$ verbundene untere Wortleitung auf.

Die für jede Speicherspalte (Elemte 11 und n1 bzw. 1m und nm) gemeinsamen komplementären Bitleitungen Bo und $\overline{Bo}$ bzw. Bm und $\overline{Bm}$ sind über Auswahlschalter Y1 bzw. Ym und über die bereits im Zusammenhang mit der Figur 2 beschriebene Bitleitungsstromquellen IB mit dem ersten Potential $V_{EE}$ einerseits und über Lesetransistoren TL21, TL11 bzw. TL2m, TL1m in der Weise mit den Eingängen des Differenzverstärkers Do verbunden, daß die Bitleitungen Bo und Bm über die Lesetransistoren einen Eingang des Differenzverstärkers Do und die komplementären Bitleitungen $\overline{Bo}$ und $\overline{Bm}$ über die Lesetransistoren den zweiten Eingang des Differenzverstärkers Do beaufschlagen. Die Basiselektroden aller Lesetransistoren TL21, TL11, TL2m, TL1m sind mit der als gestrichelter Kasten dargestellten Lesestromquelle IA verbunden. Die Basiselektroden der mit den nichtkomplementären Bitleitungen Bo und Bm verbundenen Lesetransistoren TL21 und TL2m sind über den Widerstand R20 mit ihren Kollektoren verbunden, während die Basiselektroden der mit den komplementären Leitungen $\overline{Bo}$ und $\overline{Bm}$ verbundenen Lesetransistoren TL11 und TL1m über den Widerstand R10 mit ihren Kollektoren verbunden sind.

Als Konstantstromquellen IB, IUWN, IUW1,die auf ein unteres Potential($V_{EE}$ negativ)bezogen sind, eignen sich übliche Stromquellen in stromgegengekoppelter Emitterschaltung (vgl. z.B. U. Tietze und CH.Schenk, Halbleiter-Schaltungstechnik, 5.Auflage, Springer Verlag Berlin-Heidelberg,New York, 1980, S.53, 54). Als Leseverstärker Do kann ein Differenzverstärker mit hoher Gleichtaktunterdrückung (common mode rejection ratio) üblicher Bauart vorgesehen werden.

Steht als Lesestromquelle IA aus insbesondere fertigungstechnischen Gründen kein Komplementärtransistor zur Verfügung, so kann die in der Figur 3 im gestrichelten Kasten/$IA$ gezeigte Stromquellenschaltung, die von einem hohen Potential ($V_{CC}$ positiv)beaufschlagt wird vorteilhafterweise verwendet werden.

Diese Stromquellenschaltung besteht aus einer zwischen dem zweiten Potential $V_{CC}$ und dem ersten Potential $V_{EE}$ geschalteten Reihenschaltung eines ersten Widerstandes R1, einer Diode T11, der Kollektor-Emitter-Strecke eines ersten Transistors T12, eines zweiten Widerstandes R2 und einer ersten Konstantstromquelle IV, wobei die erste Konstantstromquelle IV mit dem ersten Potential $V_{EE}$ verbunden ist. Weiterhin ist zwischen dem zweiten Potential $V_{CC}$ und dem ersten Potential $V_{EE}$ eine Reihenschaltung eines dritten Widerstandes R3 und einer zweiten Konstantstromquelle $IA^{+}$, wobei die zweite Konstantstromquelle $IA^{+}$ mit dem ersten Potential $V_{EE}$

verbunden ist, vorgesehen. Ein zweiter Transistor T21, dessen Kollektor mit dem zweiten Potential $V_{CC}$, dessen Emitter mit der Basis des ersten Transistors T12 und dessen Basis mit dem Verbindungspunkt zwischen dritten Widerstand R3 und zweiter Konstantstromquelle $IA^+$ verbunden sind, und ein dritter Transistor T22, dessen Kollektor mit dem Emitter des zweiten Transistors T21, dessen Emitter mit dem Verbindungspunkt zwischen zweiten Widerstand R2 und erster Konstantstromquelle IV und dessen Basis mit dem Verbindungspunkt zwischen Diode T11 und Kollektor des ersten Transistors T12 verbunden ist, vervollständigen die Stromquellenschaltung, wobei der Lesestrom $I_A$ am Verbindungspunkt zwischen ersten Widerstand R1 und Diode T11 entnehmbar ist und als Transistoren Transistoren gleichen Leitungstyps verwendet sind. Die Konstantstromquellen IV und $IA^+$ können entsprechend den Stromquellen IB gestaltet werden.

Für die so ausgeführte Stromquellenschaltung gilt mit R1 = R2 = R3 = R, VR1 = Verbindungspunkt zwischen R1 u. T11, UBE (Tn) = Basis-Emitter-Spannung des Transistors Tn, I = Strom durch T11 und R2:

$$I_A^+ R + UBE \ (T21) + UBE \ (T12) + IR =$$

VR1 + UBE (T11) + UBE (T22)
Da T11 und T12 sowie T21 und T22 jeweils vom gleichen Strom durchflossen sind, gilt:

UBE(T 11) = UBE (T12) und
UBE (T21) = UBE (T22).

Mit $I_A + I = VR1/R$ ist dann $I_A = I_A^+$.

$I_A$ ist damit unabhängig von VR1, also eine eingeprägte Stromquelle.

Dieses ist gültig für $0 > VR1 > -IV \cdot R$.

Ein weiteres Ausführungsbeispiel einer erfindungsgemäßen Schaltungsanordnung zeigt die Figur 4,in der entsprechend der Figur 3 vier Speicherelemente 11,n1, 1m, nm
vorgesehen sind. Bei diesem Ausführungsbeispiel sind die
Basiselektroden der mit den nicht komlementären Bitleitungen
Bo und Bm verbundenen Lesetransistoren TL21 und TL2m mit
dem invertierenden ersten Eingang 2 des Leseverstärkers Do
verbunden,während die Kollektorelektroden dieser Transistoren TL21 und TL2m mit dem zweiten Eingang 3 des Leseverstärkers Do verbunden sind. Die Basiselektroden der mit
den komplementären Bitleitungen $\overline{Bo}$ und $\overline{Bm}$ verbundenen
Lesetransistoren TL11 und TL1m sind mit dem zweiten Ein-
gang/des Leseverstärkers Do verbunden, die Kollektoren
dieser Transistoren TL11 und TL 1m sind mit dem ersten
Eingang 2 des Leseverstärkers Do verbunden.

Die vom zweiten Potential $V_{CC}$ beaufschlagte Lesestromquelle
IA ist über einen ersten Widerstand R30 mit dem zweiten
Eingang 3 des Leseverstärkers Do verbunden, während sie
über den zweiten Lesewiderstand R40 mit dem ersten Eingang 2
des Leseverstörkers Do verbunden ist.

Durch diese Schaltung, bei der die im Kollektorkreis der
Lesetransistoren angeordneten Widerstände zur Stromquelle
geführt sind, kommt man mit zwei Sammelschienen, d.h. für
alle Speicherspalten benötigte Leitungen, aus. Diese
Schaltung benötigt etwas höhere Bitleitungshübe als die
Schaltung nach Figur 3, hat dafür aber eine höhere Störsicherheit.

4 Figuren
7 Patentansprüche

Patentansprüche

1. Schaltungsanordnung zum Lesen bipolarer Speicherzellen, bei denen ein Speicherelement (MO, M1, R5, R6) aus zwei rückgekoppelten, jeweils aus einem Multiemittertransistor (MO, M1) und einem Lastelement (R5, R6) gebildeten Invertern · besteht und zwei komplementäre Bitleitungen (Bo, $\overline{\text{Bo}}$ ) aufweist, die mit je einem Emitter (EOo, EO1) der beiden Multiemittertransistoren (MO, M1) verbunden sind und über je eine Bitleitungsstromquelle (IBO, IB1) mit einem ersten Potential ($V_{EE}$) verbindbar sind, mit einem Differenzverstärker (Do), dessen Eingänge über die Kollektor-Emitter-Strecken von Lesetransistoren (TL1, TL2) mit den komplementären Bitleitungen (Bo, $\overline{\text{Bo}}$) verbunden sind, d a d u r c h g e k e n n z e i c h n e t, daß jede Bitleitung (Bo, $\overline{\text{Bo}}$) über eine Diodenstrecke (TL1, TL2) mit einer, von einem zweiten Potential ($V_{CC}$) beaufschlagten Lesestromquelle (IA) verbunden ist.

2. Schaltungsanordnung nach Anspruch 1, d a d u r c h g e k e n n z e i c h n e t, daß im Kollektorkreis jedes Lesetransistors (TL1, TL2) ein Widerstandselement (R10, R20) vorgesehen ist.

3. Schaltungsanordnung nach Anspruch 1 oder 2, d a d u r c h g e k e n n z e i c h n e t, daß die Lesestromquelle (IA) mit den Basiselektroden der Lesetransistoren (TL1, TL2) verbunden ist.

4. Schaltungsanordnung nach einem der Ansprüche 1 bis 3, d a d u r c h g e k e n n z e i c h n e t, daß das Widerstandselement (R1o, R2O) zwischen Basis und Kollektor des Lesetransistors (TL1, TL2) geschaltet ist.

5. Schaltungsanordnung nach einem der Ansprüche 1 bis 3, dadurch gekennzeichnet, daß das Widerstandselement (R30, R4o) zwischen Kollektor des Lesetransistors (TL1, TL2) und Lesestromquelle (IA) geschaltet ist,

6. Schaltungsanordnung nach einem der Ansprüche 1 bis 5, dadurch gekennzeichnet, daß die Stromstärke $I_A$ der Lesestromquelle (IA) so gewählt ist, daß

$$0,5 \times I < I_A < I,$$

mit I = Summe der Stromstärken der Bitleitungsstromquellen (IB0, IB1), gilt.

7. Schaltungsanordnung nach einem der Ansprüche 1 bis 6, dadurch gekennzeichnet, daß als Lesestromquelle (IA) eine Schaltung, bestehend aus einer zwischen zweitem Potential ($V_{CC}$) und erstem Potential ($V_{EE}$) geschaltete Reihenschaltung eines ersten Widerstandes (R1), einer Diode (T11), der Kollektor-Emitter-Strecke eines ersten Transistors (T12), eines zweiten Widerstandes (R2) und einer ersten Konstantstromquelle (IV), wobei die erste Konstantstromquelle (IV) mit dem ersten Potential ($V_{EE}$) verbunden ist,

einer zwischen zweitem Potential ($V_{CC}$) und erstem Potential ($V_{EE}$) geschalteten Reihenschaltung eines dritten Widerstandes (R3) und einer zweiten Konstantstromquelle ($IA^+$), wobei die zweite Konstantstromquelle ($IA^+$) mit dem ersten Potential ($V_{EE}$) verbunden ist,

einem zweiten Tranistor (T21), dessen Kollektor mit dem Potential ($V_{CC}$), dessen Emitter mit der Basis des ersten Transistors (T12) und dessen Basis mit dem Verbindungspunkt zwischen drittem Widerstand (R3) und zweiter Konstantstromquelle ($IA^+$) verbunden sind, und

0100851

82 P 1 5 5 9 E

einem dritten Transistor (T22), dessen Kollektor mit dem
Emitter des zweiten Transistors (T21), dessen Emitter
mit dem Verbindungspunkt zwischen zweiten Widerstand (R2)
und erster Konstantstromquelle (IV) und dessen Basis mit dem
Verbindungspunkt zwischen Diode (T11) und Kollektor des
ersten Transistors (T12) verbunden sind,
wobei der von der Lesestromquelle (IA) gelieferte Lesestrom ($I_A$) am Verbindungspunkt zwischen erstem Widerstand
(R1) und Diode (T11) entnehmbar ist und als Transistoren
Transistoren gleichen Leitungstyps verwendet sind, vorgesehen ist.

1/2
FIG 1

FIG 2

FIG 3

FIG 4